(19) Europäisches Patentamt

European Patent Office

Office européen des brevets

(11) **EP 0 821 478 B1**

(12) **EUROPÄISCHE PATENTSCHRIFT**

(45) Veröffentlichungstag und Bekanntmachung des Hinweises auf die Patenterteilung:
**03.03.2004 Patentblatt 2004/10**

(51) Int Cl.[7]: **H03G 3/30**, H03G 3/34, H04H 1/00

(21) Anmeldenummer: **97112876.4**

(22) Anmeldetag: **25.07.1997**

(54) **Elektrische Stummsteuerschaltung**

Electrical muting circuit

Circuit de silencieux électrique

(84) Benannte Vertragsstaaten:
**FR GB IT**

(30) Priorität: **26.07.1996 DE 19630395**

(43) Veröffentlichungstag der Anmeldung:
**28.01.1998 Patentblatt 1998/05**

(73) Patentinhaber: **SGS-THOMSON MICROELECTRONICS GMBH**
**85630 Grasbrunn (DE)**

(72) Erfinder: **Viebach, Michael**
**83059 Kolbermoor (DE)**

(74) Vertreter: **Hirsch, Peter, Dipl.-Ing.**
**Klunker Schmitt-Nilson Hirsch**
**Winzererstrasse 106**
**80797 München (DE)**

(56) Entgegenhaltungen:
**US-A- 4 675 867**

• **PATENT ABSTRACTS OF JAPAN vol. 097, no. 005, 30. Mai 1997 (1997-05-30) & JP 09 023123 A (SONY CORP), 21. Januar 1997 (1997-01-21)**
• **PATENT ABSTRACTS OF JAPAN vol. 008, no. 048 (P-258), 3. März 1984 (1984-03-03) & JP 58 199403 A (AKAI DENKI KK), 19. November 1983 (1983-11-19)**
• **PATENT ABSTRACTS OF JAPAN vol. 098, no. 011, 30. September 1998 (1998-09-30) & JP 10 163895 A (SANYO ELECTRIC CO LTD), 19. Juni 1998 (1998-06-19)**

**Beschreibung**

Die Erfindung betrifft eine elektrische Stummsteuerschaltung zum weichen Stummsteuern eines Audiosignals gemäß dem Oberbegriff des Patentanspruchs 1, wie sie aus PATENT ABSTRACTS OF JAPAN vol. 008, no. 048 (P-258), 3. März 1984 und der JP 58 199403 A bekannt ist.

Bei heutigen Audiogeräten besteht die Möglichkeit, diese während bestimmter Umschaltvorgänge in einen Stummzustand (Muting) zu schalten, um zu vermeiden, daß während des Umschaltens auftretende Schaltgeräusche in den Lautsprechern hörbar werden.

Ein Beispiel sind RDS-Radiogeräte, die zur Verarbeitung von RDS-Signalen in der Lage sind. RDS steht für Radio Data System und bedeutet, daß vom Rundfunksender nicht hörbare Signale mit ausgesendet werden, die beispielsweise zur Anzeige des Namens oder einer Abkürzung des gerade empfangenen Senders dienen und Information über weitere als die empfangene Senderfrequenzen des empfangenen Rundfunkprogramms enthalten.

Es gibt verschiedene Vorschläge, den Hörer eines RDS-Empfängers vor Rauschen bei zu schlechter Empfangsqualität oder vor anderen Störgeräuschen zu schützen.

Aus der DE 42 27 680 A1 ist ein FM-Empfänger mit RDS-Auswertung bekannt, welcher beim Empfang eines RDS-Programms auf einer ersten Frequenz zeitweise auf wenigstens eine zweite alternative Frequenz des empfangenen Programms zur Überprüfung von deren Empfangsqualität schaltet, wobei der Empfänger während der Überprüfung wiedergabeseitig stumm geschaltet wird.

Aus der DE 43 18 667 A1 ist ein Audiogerät mit einem RDS-Empfänger, einem CD-Abspielgerät und einem Bandabspielgerät bekannt, bei welchem dann, wenn die Empfangsqualität zu schlecht zu werden droht, bspw. im Fall eines RDS-Autoradios bei der Annäherung an einen Tunnel, dadurch verursachtes unangenehmes Rauschen vermieden wird, indem während der Zeit des Abfallens der Empfangsqualität unter einen bestimmten Schwellenwert automatisch auf Wiedergabe des Audiosignals von dem CD-Abspielgerät bzw. dem Bandabspielgerät umgeschaltet wird.

Aus der DE 43 09 518 A1 ist ein RDS-Empfangsgerät bekannt, bei dem das NF-Signal bei zu schlechter Empfangsqualität vorübergehend gedämpft wird. Zu diesem Zweck werden laufend ein von der Feldstärke abhängiges Hilfssignal und ein weiteres Hilfssignal aus dem demodulierten Signal abgeleitet und werden diese beiden Hilfssignale zur Bildung des Qualitätssignals kombiniert. Mit dem einen Hilfssignal wird bewertet, ob es oberhalb von 60 kHz Amplituden von Signalanteilen gibt, die oberhalb eines Schwellenwertes liegen. Mit dem zweiten Hilfssignal wird bewertet, ob die beiden Seitenbänder der Zwei-Seitenband-Amplitudenmodulation symmetrisch zum Träger liegen oder nicht.

Eine diesbezügliche Asymmetrie zeigt an, daß im NF-Signal eine hörbare Störung vorliegt.

Ein Merkmal von RDS-Radiogeräten besteht darin, daß dann, wenn die Empfangsqualität des gerade empfangenen Senderprogramms unter einen bestimmten Qualitätswert abfällt, automatisch auf eine andere der im RDS-Signal mitgeteilten Empfangsfrequenzen desselben Programms umgeschaltet wird.

Man hat Lösungen gefunden, welche erlauben, den Umschaltvorgang so schnell durchzuführen, daß der Hörer die Umschaltung auf eine andere Empfangsfrequenz garnicht bemerkt. Während eines solchen Frequenzumschaltsprungs wird das Audiogerät kurzzeitig in einen Mute- oder Stummzustand geschaltet. Ein abruptes Umschalten in den Stummzustand verursacht Knack-Geräusche am Lautsprecherausgang. Diese kann man durch einen weichen Stummschaltungsübergang oder weiches Muting vermeiden und dadurch den Umschaltvorgang für den Hörer noch unauffälliger machen.

Bei einer herkömmlichen Stummsteuerschaltung zum weichen Stummsteuern eines Audiosignals verwendet man einen Kondensator, der mit einer vorbestimmten Zeitkonstante aufgeladen oder entladen wird, je nachdem, ob man weich in den Stummschaltzustand geht oder weich den Stummschaltzustand verläßt. Die ansteigende Ladespannung oder abfallende Entladespannung des Kondensators wird als Dämpfungsrampe benutzt, mittels welcher beim Stummsteuern die Amplitude des zu dämpfenden Signals zunehmend bis auf Null reduziert und beim Verlassen des Stummzustandes die Amplitude des Signals von Null aus zunehmend vergrößert wird. Dies gelingt mit vertretbarem Aufwand jedoch nur unvollständig. Es wird fast nur die Hüllkurve des stummzuschaltenden Signals entsprechend der Dämpfungsrampe zunehmend verkleinert bzw. vergrößert, da sich bei einfachen Schaltungen nur ein Klemm- oder Begrenzungsvorgang ergibt, bei welchem das stummzuschaltende Signal entsprechend der Dämpfungsrampe zunehmend stärker oder schwächer begrenzt wird.

Problematisch bei dieser weichen Stummschaltung herkömmlicher Art ist einerseits, daß die zur Beschneidung der Amplitude führende Begrenzung zum Klirren des begrenzten Audiosignals während des Stummschaltvorgangs führt und daß andererseits für dieses weiche Stummschalten ein Kondensator erforderlich ist. Audiosignalprozessoren, die derartige Signalverarbeitungen durchführen, sind heutzutage als monolithisch hochintegrierte Schaltungen ausgeführt. Kondensatoren, wie sie für weiches Stummschalten erforderlich sind, kann man wegen der benötigten langen Zeitkonstanten mit vernünftigem Aufwand auf solchen integrierten Schaltungen nicht unterbringen und müssen daher als externe Kondensatoren ausgeführt werden. Der Anwender kann durch die Festlegung der Kondensatorgröße nur eine Zeitkonstante für den Stummschaltvorgang festlegen. Solch ein externer Kondensator führt nicht nur zu einer Erhöhung der Gesamtosten sondern erfordert auch einen zusätzlichen Anschlußstift der integrierten Schaltung. Integrierte Schaltungen mit einer hohen Anzahl von Anschlußstiften machen aufwendige Chipgehäuse erforderlich, mit entsprechender Kostenfolge.

Die Anmelderin hat einen monolithisch integrierten Audiosignalprozessor entwickelt, der die Audiosignalverarbeitung eines Stereo-Radiogerätes in sehr weitem Umfang durchführt. Für ihren Betrieb greift diese integrierte Schaltung auf eine Anzahl externer Schaltungskomponenten zurück, bei denen es sich vorwiegend um Kondensatoren handelt. Durch eine Vielzahl von Maßnahmen ist es der Anmelderin gelungen, eine monolithisch integrierte Schaltung für Audiosignalverarbeitung zu schaffen, die mit erheblich weniger externen Schaltungskomponenten auskommt, mit entsprechender Einsparung von Anschlußstiften gegenüber der herkömmlichen integrierten Schaltung. Dies führt zu erheblicher Kosteneinsparung, einerseits dadurch, daß für die integrierte Schaltung ein einfacheres Gehäuse verwendet werden kann, und andererseits dadurch, daß eine erhebliche Anzahl externer Schaltungskomponenten eingespart werden kann.

Im Rahmen der Schaffung dieser verbesserten integrierten Schaltung *sollen der* externe Kondensator und der dazu gehörige Anschlußstift, die man bei den genannten Lösungen für weiches Stummschalten benötigt hat, *vermieden werden.*

Dies hat man erreicht mit einer elektrischen Stummsteuerschaltung zum weichen Stummsteuern eines Audiosignals, die aus den bereits erwähnten PATENT ABSTRACTS OF JAPAN vol. 008, no. 048 (P-258), 3. März 1984 und der JP 58 199403 A bekannt ist und die eine digital steuerbare Dämpfungsschaltung aufweist, die einen Audiosignaleingang, einen Audiosignalausgang und einen Steuersignaleingang besitzt, und die des weiteren einen Aufwärts/Abwärts-Zähler umfaßt, der einen Zählstandssignalausgang aufweist, an dem ein digitales Zählstandssignal abnehmbar ist und der mit dem Steuersignaleingang der Dämpfungsschaltung verbunden ist.

Aus der US 4 675 867 A ist eine Datenverarbeitungsschaltung zum Stummschalten von Informationssignalen bekannt, bei welcher ebenfalls ein Aufwärts/Abwärtszähler verwendet wird, der unter dem Einfluss einer Steuerschaltung für das Steuern eines Stummschaltungsbeginns und eines Stummschaltungsendes steht.

Die vorliegende Erfindung schafft eine Stummsteuerschaltung, wie sie im Patentanspruch 1 angegeben ist und die sich gegenüber der oberbegriffsmäßigen Stummsteuerschaltung dadurch auszeichnet, dass der Aufwärts/Abwärts-Zähler einen Taktimpulseingang für die Zuführung von zu zählenden Taktimpulsen und einen Zählsteuereingang für die Zuführung eines Zählstart und Zählstop steuernden Zählsteuersignals aufweist, dass von dem Zählstandsignalausgang des Zählers an den Steuersignaleingang der Dämpfungsschaltung ein digitales Zählstandssignal in Form eines n-stelligen Datenwortes lieferbar ist, wobei n eine vorbestimmte ganze Zahl ist, und dass die Dämpfungsschaltung eine zwischen den Audiosignaleingang und einen Signalmasseanschluß geschaltete Parallelschaltung mit n Dämpfungsgliedern enthält, die je aufweisen: einen mit dem Audiosignalausgang verbundenen Teilspannungsabgriff, eine zwischen den Audiosignaleingang und den Teilspannungsabgriff geschaltete erste Reihenschaltung mit einem ersten Widerstand und einem ersten steuerbaren Schalter, eine zwischen den Teilspannungsabgriff und den Signalmasseanschluß geschaltete zweite Reihenschaltung mit einem zweiten Widerstand und einem zweiten gesteuerten Schalter und eine Schaltersteuereinrichtung, über welche die beiden Schalter eines jeden Dämpfungsgliedes gegenläufig steuerbar sind, derart, daß jeweils einer der beiden Schalter leitend und der jeweils andere Schalter nichtleitend geschaltet ist, wobei den Schaltersteuereinrichtungen der Dämpfungsglieder je eine andere der n Stellen des Datenwortes als Schaltsteuersignal zuführbar ist und wobei die Widerstandswerte der Widerstände der einzelnen Dämpfungsglieder verschieden sind, und zwar in Abhängigkeit von den Wertigkeiten der den einzelnen Dämpfungsgliedern zugeordneten Stellen des Datenwortes.

Diese weich in den Stummzustand steuernde bzw. weich aus dem Stummzustand heraussteuernde Stummsteuerschaltung ist gänzlich mit Schaltungskomponenten realisierbar, die sich problemlos monolithisch integrieren lassen, und erfordert daher keine externen Schaltungskomponenten und keine dafür vorgesehenen Anschlußstifte mehr.

Da bei der erfindungsgemäßen Stummsteuerschaltung eine echte Dämpfung des stummzuschaltenden Audiosignals durchgeführt wird und nicht eine Amplitudenbeschneidung, wird bei der erfindungsgemäßen Stummsteuerschaltung auch das bei der herkömmlichen Schaltung entstehende Klirren vermieden.

Läßt man den Zähler Taktimpulse eines Taktsignals mit konstanter Taktfrequenz zählen, führt dies zu einem Stummschalten bzw. Herausführen aus dem Stummzustand mit einer sich linear ändernden Signalamplitude. Man kann aber auch ein Taktimpulssignal verwenden, dessen Taktfrequenz in vorbestimmter Weise änderbar ist. Auf diese Weise kann man die Dämpfungskurve, mit welcher die Stärke des Audiosignals beim Stummschalten bzw. Herausführen aus dem Stummzustand verändert wird, anders als linear gestalten.

Zu diesem Zweck kann man eine Taktimpulsquelle mit variabler Taktfrequenz verwenden. Eine andere Möglichkeit ist die, mehrere Taktimpulsquellen mit unterschiedlichen Taktfrequenzen zu benutzen und zwischen diese Taktimpulsquellen und den Taktimpulseingang des Zählers eine Auswahleinrichtung, vorzugsweise in Form eines elektronischen Auswahlschalters, zu schalten, mittels welcher jeweils eine bestimmte der Taktimpulsquellen auswählbar ist. Man kann die Auswahleinrichtung nach einem oder mehreren Auswahlprogrammen steuerbar machen, unter dessen Steuerung dem Taktimpulseingang des Zählers ein Taktsignal mit sich in vorbestimmter Weise ändernder Taktfrequenz zuführbar ist. Auf diese Weise kann man eine bestimmte Dämpfungskurve beim Stummschalten bzw. Herausführen aus dem Stummzustand steuern.

Der Einfachheit halber soll nachfolgend der Begriff Stummschalten nicht nur den Vorgang des Dämpfens des Audiosignals in den Stummzustand sondern auch das Herausführen des Audiosignals aus dem Stummzustand durch dessen Anwachsenlassen von Null aus mit umfassen.

Eine mit erfindungsgemäßen Dämpfungsgliedern aufgebaute Stummsteuerschaltung hat unter anderem den Vorteil, daß im Ruhezustand, also außerhalb der Stummschaltungsvorgänge, keine Querströme durch die Dämpfungsschaltung fließen, da im Ruhezustand immer alle ersten oder alle zweiten Schalter nichtleitend gesteuert sind. Bei dieser Dämpfungsschaltung entsteht somit außerhalb der Vorgänge des Hineinsteuerns in den Stummzustand und des Heraussteuerns aus dem Stummzustand kein Leistungsverlust.

Besonders bevorzugt wird eine Dämpfungsschaltung, bei welcher die Schalter der Dämpfungsglieder je mit einem MOS-Schalter aufgebaut sind, der die Doppelfunktion sowohl des Schalters als auch des zugehörigen Widerstandes hat, wobei dessen Einschaltwiderstand den je zugehörigen Widerstand des Dämpfungsgliedes bildet. Besonders vorteilhaft bei dieser Ausführungsform ist einerseits, daß weder Widerstände noch Kondensatoren erforderlich sind, und andererseits daß sich die gesamte Stummsteuerschaltung in reiner MOS-Prozeßtechnik herstellen läßt, also mit einer relativ einfachen Herstellungstechnologie.

Jeder der MOS-Schalter kann durch einen einzigen MOS-Transistor realisiert werden. Bevorzugtermaßen wird jedoch jeder der MOS-Schalter mit einer Parallelschaltung aufgebaut, die einen einen N-Kanal aufweisenden NMOS-Transistor und einen einen P-Kanal aufweisenden PMOS-Transistor aufweist, die immer gleichzeitig leitend oder nichtleitend schaltbar sind, wobei im Einschaltzustand deren parallel zueinanderliegende Einschaltwiderstände den je zugehörigen Widerstand des Dämpfungsgliedes bilden. Mit dieser Ausführungsform läßt sich eine weiter reichende Linearität für den resultierenden Einschaltwiderstand erreichen als bei der Verwendung nur eines einzigen MOS-Transistors pro Schalter, und damit lassen sich Verzerrungen des Audiosignals noch kleiner halten.

Die Zähler und Dämpfungsschaltung verbindende Datenleitung kann als parallele Datenleitung mit n-Bit-Leitungen ausgebildet sein und der Steuersignaleingang der Dämpfungsschaltung kann dementsprechend n Steuersignalanschlüsse aufweisen. Dabei können bei jedem Dämpfungsglied die Gateelektrode des zum ersten Widerstand gehörenden MOS-Transistors und die Gateelektrode des zum zweiten Widerstand gehörenden PMOS-Transistors direkt und die Gateelektrode des zum ersten Widerstand gehörenden PMOS-Transistors und die Gateelektrode des zum zweiten Widerstand gehörenden NMOS-Transistors über einen Inverter mit dem zugehörigen Steuersignalanschluß verbunden sein, oder umgekehrt. Dies führt dazu, daß das digitale Steuersignal, das dem einzelnen Dämpfungsglied zugeführt wird, das gegenläufige Schalten der beiden je durch ein Transistorpaar gebildeten Schalter des jeweiligen Dämpfungsgliedes bewirkt, bei welchem jeweils das zu dem einen Schalter gehörende Transistorpaar leitend und das jeweils zu dem anderen Schalter gehörende Transistorpaar nichtleitend gesteuert wird:

Die Erfindung wird nun anhand von Ausführungsformen näher erläutert. In den Zeichnungen zeigen:

Fig. 1    ein Blockschaltbild einer Ausführungsform einer erfindungsgemäßen Stummsteuerschaltung;

Fig. 2    Audiosignalverläufe beim Stummschalten mittels einer konstanten Taktfrequenz;

Fig. 3    Audiosignalverläufe beim Stummschalten mittels sich ändernder Taktfrequenzen;

Fig. 4    ein Blockschaltbild einer Ausführungsform einer erfindungsgemäßen Stummsteuerschaltung, deren Dämpfungsschaltung Dämpfungsglieder einer ersten Art aufweist; und

Fig. 5    ein Dämpfungsglied einer zweiten Art, das für eine Dämpfungsschaltung einer erfindungsgemäßen Stummsteuerschaltung verwendbar ist.

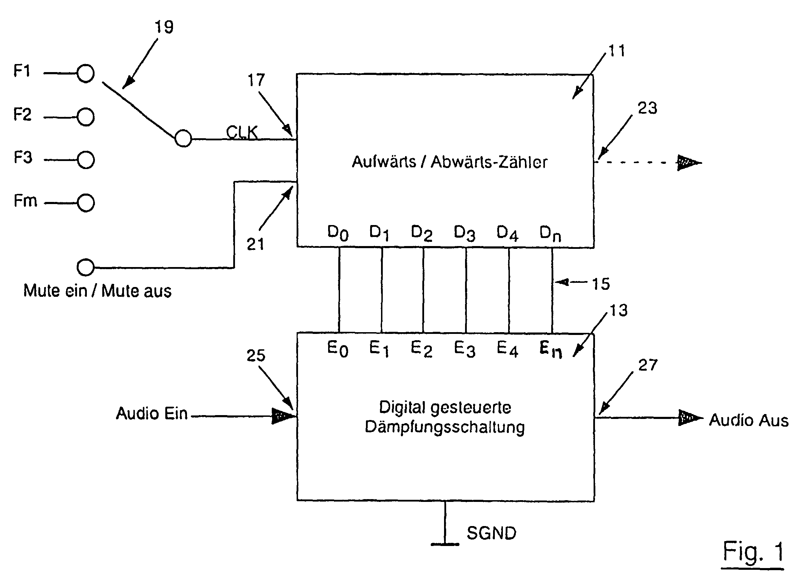

Die in Fig. 1 gezeigte Stummsteuerschaltung umfaßt einen Aufwärts/Abwärts-Zähler 11 und eine digital gesteuerte Dämpfungsschaltung 13, die über eine parallele Datenlei tung 15 miteinander verbunden sind, die bei der in Fig. 1 gezeigten Ausführungsform sechs Einzelleitungen umfaßt.

Der Zähler 11 weist einen Taktimpulseingang 17 auf, dem zu zählende Taktimpulse CLK zuführbar sind. Der Taktimpuls eingang 17 ist über einen Auswahlschalter 19 wahlweise mit einer von mehreren Taktimpulsquellen F1, F2, F3, .... Fm verbindbar, die je eine andere Taktfrequenz aufweisen. Außerdem besitzt der Zähler einen Zählsteuereingang 21 für die Zuführung eines Zählstart und Zählstopp steuernden Zählsteuersignals MUTE EIN / MUTE AUS. Desweiteren besitzt der Zähler 11 einen Steuersignalausgang 23, an dem der Zähler 11 am Ende eines jeden Mute- oder Stummsteuervorgangs ein Signal MUTE FERTIG abgibt. Schließlich weist der Zähler 11 einen Zählstandsignalausgang mit n Zählstandsignalausgangsanschlüssen D0, D1, D2, D3, D4 .... Dn auf, deren Anzahl n der Anzahl der Einzelleitungen der Datenleitung 15 entspricht.

Die Dämpfungsschaltung 13 besitzt einen Audiosignaleingang 25, einen Audiosignalausgang 27, einen Signalmasseanschluß SGND und einen Steuersignaleingang mit n Steuersignaleingangsanschlüssen E0, E1, E2, E3, E4, .... En, wobei n wieder gleich der Anzahl der Einzelleitungen der Datenleitung 15 ist.

Über die Datenleitung 15 wird der jeweils erreichte Zählstand des Zählers 11 durch ein den Zählstand im Dualzahlensystem darstellendes n-stelliges Datenwort übertragen, wobei n eine ganze Zahl ist. Bei der in Fig. 1 dargestellten Ausführungsform ist n = 6.

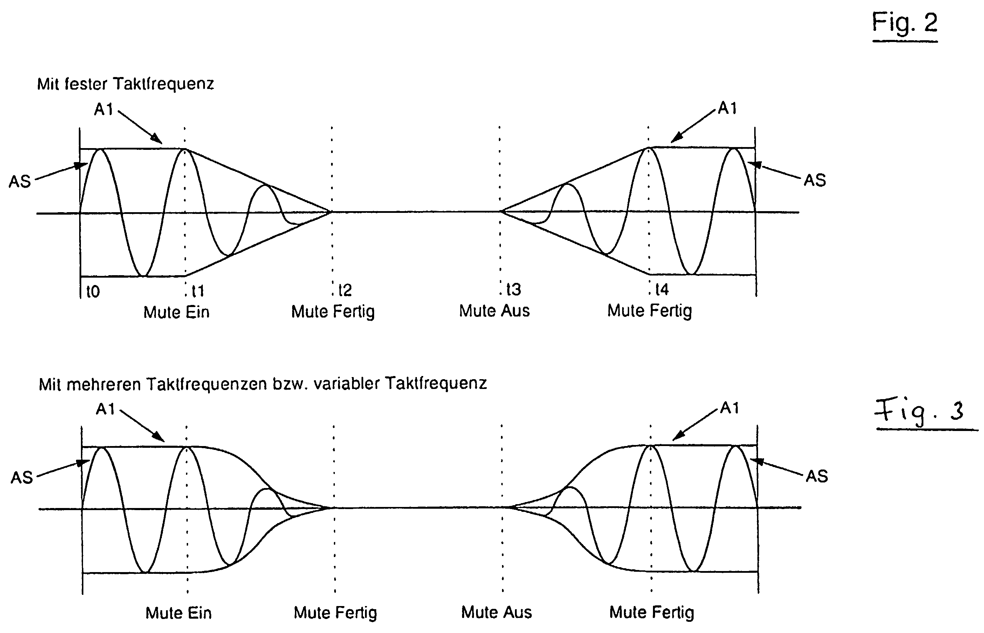

Unter Zuhilfenahme der Fig. 2 und 3 wird nun die Funktionsweise der in Fig. 1 gezeigten Stummsteuerschaltung betrachtet.

Fig. 2 zeigt ein Audiosignal AS, das zu einem Zeitpunkt t0 eine konstante Amplitude A1 aufweist. Es sei angenommen, daß zu diesem Zeitpunkt der Taktimpulseingang 17 des Zählers 11 über den Auswahlschalter 19 mit der Taktimpulsquelle F1 verbunden ist.

Zu einem Zeitpunkt t1 wird dem Zählsteuereingang 21 des Zählers 11 ein Signal MUTE EIN zugeführt, das einen Zählstart des Zählers 11 in Gang setzt, woraufhin der Zähler 11 die ihm zugeführten Taktimpulse CLK zu zählen beginnt. B,ei einer schrittweisen Veränderung des Zählstandes des Zählers 11 wird der Gesamtdämpfungsfaktor der digital gesteuerten Dämpfungsschaltung 13 schrittweise verändert, die Amplitude des durch die Dämpfungsschaltung 13 hindurchgeschickten Audiosignals somit schrittweise verändert. Bei einem bestimmten ersten Zählstand des Zählers 11 wird das Audiosignal minimal gedämpft, während es bei einem anderen vorbestimmten Zählstand des Zählers maximal gedämpft wird. Beginnend beim Zeitpunkt t1 beginnt der Zähler von dem minimale Signaldämpfung oder im wesentlichen keine Signaldämpfung bewirkende Zählstand aus mit der Zählung in Richtung zu dem maximale Dämpfung bewirkenden Zählstand, der zum Zeitpunkt t2 erreicht wird. Zu diesem Zeitpunkt ist das Audiosignal AS auf Null oder im wesentlichen Null gedämpft, der Vorgang des weichen Stummschaltens somit beendet. Bei diesem Zählstand gibt der Zähler über seinen Steuersignalausgang 23 ein Signal MUTE FERTIG ab, das zu anderweitiger Steuerung verwendet werden kann, beispielsweise um einen im Stummzustand durchzuführenden Umschaltvorgang auszulösen, beispielsweise einen RDS-Frequenzsprung.

Ist der Vorgang, während welchem eine Stummschaltung erwünscht ist, zum Zeitpunkt t3 beendet, wird mittels der in Fig. 1 gezeigten Stummschaltung eine Rückführung des Audiosignals AS zu seiner ungedämpften Amplitude A1 begonnen. Hierfür beginnt der Zähler in umgekehrter Richtung als zwischen den Zeitpunkten t1 und t2 zu zählen, was eine schrittweise geringere Dämpfung des Audiosignals AS durch die Dämpfungsschaltung 13 und somit dessen schrittweise Erhöhung zur Folge hat. Zum Zeitpunkt t4 ist dann wieder der minimale Dämpfung bewirkende Zählstand des Zählers 11 erreicht. Zu diesem Zeitpunkt wird über den Steuersignalausgang 23 des Zählers 11 wieder ein Signal MUTE FERTIG abgegeben.

Da dem Taktimpulseingang 17 des Zähles 11 bei dem in Fig. 2 dargestellten Stummschaltvorgang ein Taktimpulssignal mit gleichbleibender Taktfrequenz zugeführt wird, kommt es zu der in Fig. 2 dargestellten konstanten Amplitudenänderung.

Fig. 3 zeigt Stummschaltvorgänge, bei denen die Amplitudendämpfung während der Vorgänge des Stummschaltens bzw. des Herausführens aus dem Stummzustand nicht mit konstanter Amplitudenänderung verlaufen sondern nach einer vorbestimmten nichtlinearen Kennlinie. Dies erreicht man dadurch, daß man zu vorbestimmten Zeitpunkten, die zwischen t1 und t2 liegen, den Auswahlschalter 19 nacheinander auf verschiedene der Taktimpulsquellen F1 bis Fm schaltet, so daß die Zählgeschwindigkeit des Zählers 11 entsprechend verändert wird. Dies führt zu einer entsprechend unterschiedlich schnellen Dämpfungsänderung der Dämpfungsschaltung 13 und damit zu dem nichtlinearen Dämpfungsverlauf gemäß Fig. 3.

Man kann den Auswahlschalter 19, der vorzugweise als elektronische Schaltereinrichtung ausgebildet ist, mittels eines Auswahlprogramms steuern, das nach Auslösung eines Stummschaltvorgangs automatisch eine programmgemäße Umschaltung des Auswahlschalters 19 steuert. Dieses Auswahlprogramm kann man den einzelnen Anwendungsfällen entsprechend gestalten.

Das Signal MUTE FERTIG kann auch dazu verwendet werden, den Zähler 11 beim Abschluß eines Stummschaltvorgangs zum Zeitpunkt t2 bzw. beim Abschluß eines Vorgangs zur Herausführung aus der Stummschaltung zum Zeitpunkt t4 für die jeweils andere Zählrichtung vorzubereiten. Eine andere Möglichkeit besteht darin, beim Erreichen des maximalen Zählwertes des Zählers 11 ein Überlauf-Bit zu erzeugen, mittels welchem die Umschaltung der Zählrichtung des Zählers 11 gesteuert wird.

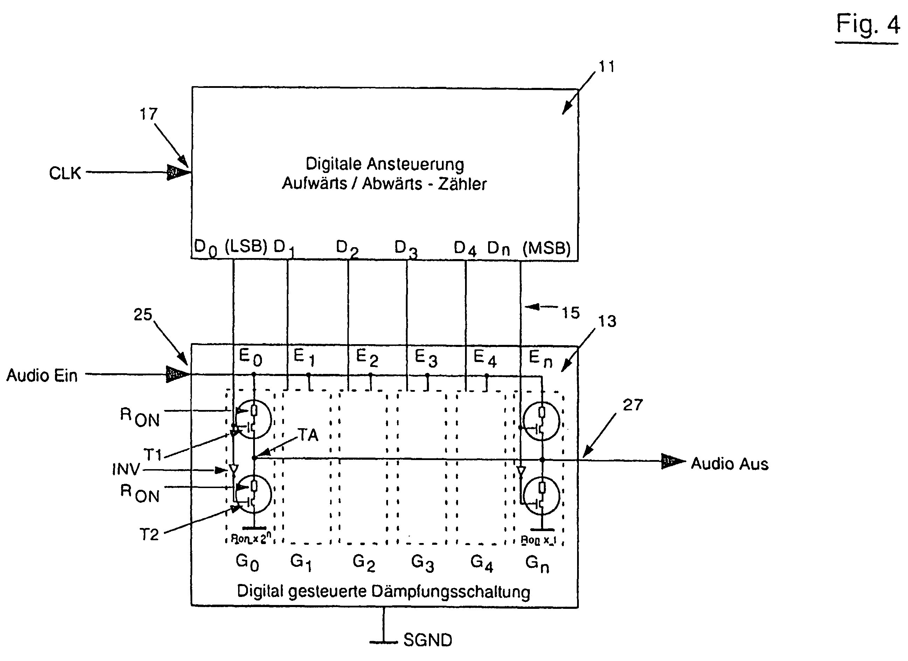

Fig. 4 zeigt eine Ausführungsform einer Stummschaltung, bei welcher die Dämpfungsschaltung 13 eine zwischen den Audiosignaleingang 25 und den Audiosignalausgang 27 geschaltete Parallelschaltung mit n Dämpfungsgliedern S0, S1, ... Sn aufweist. Jedes dieser Dämpfungsglieder besitzt einen mit dem Audiosignalausgang 27 verbundenen Teilspannungsabgriff TA sowie einen zwischen den Audiosignaleingang 25 und den Teilspannungsabgriff TA geschalteten ersten MOS-Transistor T1 und einen zwischen den Teilspannungsabgriff TA und den Signalmasseanschluß SGND geschalteten zweiten MOS-Transistor T2. Jeder dieser MOS-Transistoren stellt praktisch die Reihenschaltung aus einem Einschaltwiderstand Ron und einem durch den Schalttransistor gebildeten elektronischen Schalter dar. Die Gateelektroden von T1 und T2 der einzelnen Dämpfungsglieder S0 bis Sn sind je mit einem der Zählstandsignalausgangsanschlüsse D0 bis Dn verbunden, und zwar die Gateelektrode von T1 direkt und die Gateelektrode von T2 über einen Inverter INV, wenn es sich bei T1 und T2 um MOS-Transistoren des gleichen Kanaltyps handelt. Verwendet man für T1 und T2 MOS-Transistoren unterschiedlichen Kanaltyps, ist der Inverter INV nicht erforderlich. Dadurch werden die beiden Transistoren T1 und T2 gegenläufig geschaltet, derart, daß jeweils einer leitend und der jeweils andere nicht leitend geschaltet ist.

Die Einschaltwiderstände Ron der Transistoren T1 und T2 der einzelnen Dämpfungsglieder S0 bis Sn sind unterschiedlich groß, und zwar in Abhängigkeit davon, von welcher Dualzahlenstelle des über die Datenleitung 15 vom Zähler 11 jeweils an die Dämpfungsschaltung 13 übertragenen Datenwortes das jeweilige Dämpfungsglied gesteuert wird. Geht man davon aus, daß bei der betrachteten Ausführungsform den beiden Zählstandsignalausgangsanschlüssen D0 und Dn das niedrigstwertige Bit (LSB) bzw. das höchstwertige Bit (MSB) des Datenwortes zugeordnet ist, nimmt man hinsichtlich der Widerstandswerte der Einschaltwiderstände Ron der Dämpfungsglieder S0 bis Sn die Wichtung

$$Ron \times 2^n$$

vor, wobei der niedrigstwertige Einschaltwiderstand Ron x 1 dem dem höchstwertigen Bit zugeordneten Dämpfungsglied Sn zugeordnet ist, während bei dem dargestellten Ausführungsbeispiel mit sechs Zählstandssignalausgangsanschlüssen dem zum niedrigstwertigen Bit gehörenden Dämpfungsglied S0 ein Einschaltwiderstandswert Ron x $2^5$ zugeordnet ist.

Abweichend von der in Fig. 4 dargestellten Ausführungsform können die einzelnen Dämpfungsglieder S0 bis Sn auch mit voneinander bauelementemäßig getrennten Widerständen und Schaltern aufgebaut sein, wobei dann jedes Dämpfungsglied eine zwischen den Audiosignaleingang 25 und den Teilspannungsabgriff TA geschaltete erste Reihenschaltung mit einem ersten Widerstand und einem ersten steuerbaren Schalter und eine zwischen den Teilspannungsabgriff TA und den Signalmasseanschluß SGND geschaltete zweite Reihenschaltung mit einem zweiten Widerstand und einem zweiten gesteuerten Schalter aufweist.

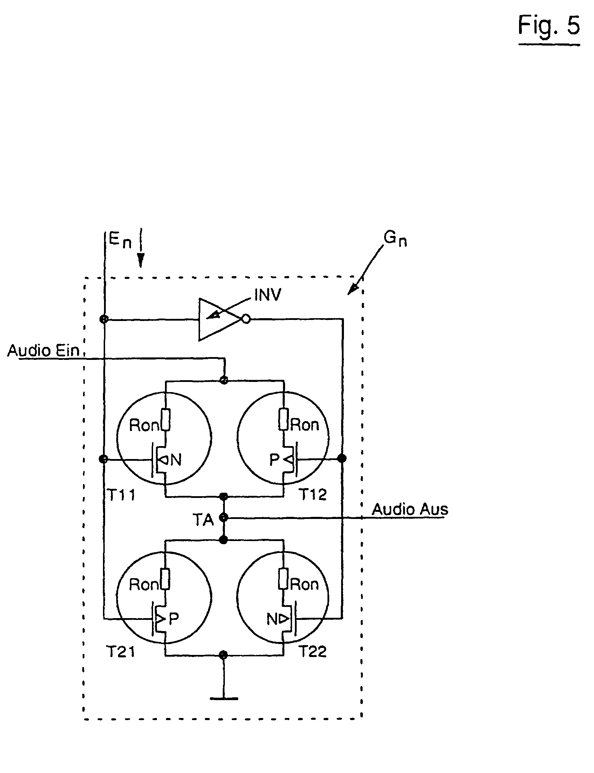

Fig. 5 zeigt eine weitere Möglichkeit eines Dämpfungsgliedes, das für die Dämpfungsschaltung 13 geeignet ist. Dabei sei angenommen, daß in Fig. 5 beispielsweise das Dämpfungsglied Sn dargestellt ist und die anderen Dämpfungsglieder S0 bis S4 identisch aufgebaut sind.

Im Unterschied zu der in Fig. 4 gezeigten Ausführungsform von Dämpfungsgliedern weist das in Fig. 5 gezeigte Dämpfungsglied zwischen dem Audiosignaleingang 25 und dem Audiosignalausgang 27 einerseits und dem Audiosignalausgang 27 und dem Signalmasseanschluß SGND andererseits je eine Parallelschaltung aus einem NMOS-Transistor T11 bzw. T22 und einem PMOS-Transistor T12 bzw. T21 auf. Die Einschaltwiderstände Ron aller vier Transistoren T11, T12, T21 und T22 sind gleich groß. Die Gateelektroden von T11 und T21 sind direkt und die Gateelektroden von T12 und T22 sind über einen Inverter INV mit dem je zugehörigen der Steuersignaleingangsanschlüsse E0 bis En verbunden. Die vier Transistoren T11, T12, T21 und T22 sind jeweils gegenläufig geschaltet, derart, daß jeweils das Transistorpaar T11 und T12 oder das Transistorpaar T21 und T22 leitend gesteuert und das jeweils andere Transistorpaar nicht leitend gesteuert ist. Mit einem derartigen Dämpfungsglied erreicht man die bereits erwähnte Linearitätsverbesserung.

Die Dämpfungsschaltung 13 bildet bei den in den Fig. 4 und 5 gezeigten Ausführungsformen zwischen dem Audiosignaleingang 25 und dem Audiosignalausgang 27 einerseits und dem Audiosignalausgang 27 und dem Signalmasseanschluß SGND andererseits je eine Parallelschaltung von mehreren Einschaltwiderständen Ron mit entsprechend dem Dualzahlensystem gewichteten Einschaltwiderstandswerten. Wieviele von den je parallel geschalteten Einschaltwiderständen unterschiedlichen Einschaltwiderstandswertes an der Parallelschaltung jeweils beteiligt sind, hängt von dem jeweiligen Datenwort ab, das über die Datenleitung 15 übertragen wird. Beispielsweise sei angenommen, daß bei einem Binärwert 0 einer Datenwortstelle bei der Ausführungsform von Fig. 4 T1 gesperrt und T2 leitend bzw. bei der Fig. 5 gezeigten Ausführungsform T11 und T12 gesperrt und T21 und T22 leitend gesteuert sind. Weisen sämtliche Stellen des Datenwortes den Binärwert 0 auf, sind sämtliche zwischen dem Audiosignaleingang 25 und dem Audiosignalausgang 27 befindliche Transistoren gesperrt, während alle zwischen dem Audiosignalausgang 27 und Signalmasse SGND befindlichen Transistoren leitend sind und die Amplitude des am Audiosignalausgang 27 auftretenden Audiosignals praktisch 0 ist. Weisen dagegen sämtliche Stellen des Datenwortes den Logikwert 1 auf, sind sämtliche zwischen dem Audiosignaleingang 25 und dem Audiosignalausgang 27 liegenden Transistoren leitend und alle zwischen dem Audiosignalausgang und der Signalmasse SGND liegenden Transistoren sperrend geschaltet, so daß das Audiosignal zwischen dem Audiosignaleingang 25 und dem Audiosignalausgang 27 praktisch keine Dämpfung erfährt. Bei Datenwörtern, bei denen ein Teil der Datenwortstellen den Logikwert 0 und ein Teil der Datenwortstellen den Logikwert 1 aufweist, tritt am Audiosignalausgang 27 eine Signalamplitude auf, die zwischen 0 und der ungedämpften Amplitude liegt.

Auf diese Weise kann man durch Verändern des Zählwertes des Zählers 11 eine sich ändernde Dämpfung der in Fig. 2 oder der in Fig. 3 gezeigten Art erreichen.

**Patentansprüche**

1. Elektrische Stummsteuerschaltung zum weichen Stummsteuern eines Audiosignals (AS),
mit einer digital steuerbaren Dämpfungsschaltung (13), die einen Audiosignaleingang (25), einen Audiosignalausgang (27) und einen Steuersignaleingang (E0 bis En) aufweist,
und mit einem Aufwärts/Abwärts-Zähler (11), der einen Zählstandsignalausgang (D0 bis Dn) aufweist, an dem ein digitales Zählstandssignal abnehmbar ist und der mit dem Steuersignaleingang (E0 bis En) der Dämpfungsschaltung (13) verbunden ist,
**dadurch gekennzeichnet,**
**dass** der Aufwärts/Abwärts-Zähler (11) einen Taktimpulseingang (17) für die Zuführung von zu zählenden Taktimpulsen (CLK) und einen Zählsteuereingang (21) für die Zuführung eines Zählstart und Zählstop steuernden Zählsteuersignals (MUTE EIN/MUTE AUS) aufweist,
**dass** von dem Zählstandsignalausgang (D0 bis Dn) des Zählers (11) an den Steuersignaleingang (E0 bis En) der Dämpfungsschaltung (13) ein digitales Zählstandssignal in Form eines n-stelligen Datenwortes lieferbar ist, wobei n eine vorbestimmte ganze Zahl ist,
und **dass** die Dämpfungsschaltung (13) eine zwischen den Audiosignaleingang (25) und einen Signalmasseanschluß (SGND) geschaltete Parallelschaltung mit n Dämpfungsgliedern (SO bis Sn) enthält, die je aufweisen:
einen mit dem Audiosignalausgang (27) verbundenen Teilspannungsabgriff (TA),
eine zwischen den Audiosignaleingang (25) und den Teilspannungsabgriff (TA) geschaltete erste Reihenschaltung mit einem ersten Widerstand (Ron) und einem ersten steuerbaren Schalter (T1),
eine zwischen den Teilspannungsabgriff (TA) und den Signalmasseanschluß (SGND) geschaltete zweite Reihenschaltung mit einem zweiten Widerstand (Ron) und einem zweiten gesteuerten Schalter (T2) und
eine Schaltersteuereinrichtung, über welche die beiden Schalter eines jeden Dämpfungsgliedes gegenläufig steuerbar sind, derart, daß jeweils einer der beiden Schalter (T1, T2) leitend und der jeweils andere Schalter (T2, T1) nichtleitend geschaltet ist,
wobei den Schaltersteuereinrichtungen der Dämpfungsglieder (SO bis Sn) je eine andere der n Stellen des Datenwortes als Schaltsteuersignal zuführbar ist
und wobei die Widerstandswerte der Widerstände (Ron) der einzelnen Dämpfungsglieder (SO bis Sn) verschieden sind, und zwar in Abhängigkeit von den Wertigkeiten der den einzelnen Dämpfungsgliedern (SO bis Sn) zugeordneten Stellen des Datenwortes.

2. Stummsteuerschaltung nach Anspruch 1, bei welcher dem Taktimpulseingang (17) des Zählers (11) ein Taktimpulssignal (CLK) mit in vorbestimmbarer Weise änderbarer Taktfrequenz zuführbar ist.

3. Stummsteuerschaltung nach Anspruch 2, bei welcher der Taktimpulseingang (17) des Zählers (11) mit einer Taktimpulsquelle mit variabler Taktfrequenz verbunden ist.

4. Stummsteuerschaltung nach Anspruch 2, bei welcher der Taktimpulseingang (17) des Zählers (11) über eine Auswahleinrichtung (19) auswählbar mit einer von mehreren Taktimpulsquellen (Fl bis Fm) unterschiedlicher Taktfrequenz verbindbar ist.

5. Stummsteuerschaltung nach einem der Ansprüche 3 bis 4,
bei welcher die variable Taktimpulsquelle bzw. die Auswahleinrichtung (19) nach mindestens einem Auswahlprogramm steuerbar ist, unter dessen Steuerung dem Taktimpulseingang (17) des Zählers (11) ein Taktsignal (CLK) mit sich in vorbestimmter Weise ändernder Taktfrequenz zuführbar ist.

6. Stummsteuerschaltung nach einem der Ansprüche 1 bis 5,
bei welcher jeder Schalter mit einem MOS-Schalter aufgebaut ist, dessen Einschaltwiderstand (Ron) den je zugehörigen Widerstand des Dämpfungsgliedes (SO bis Sn) bildet.

7. Stummsteuerschaltung nach Anspruch 6, bei welcher jeder MOS-Schalter mit einer Parallelschaltung aufgebaut ist, die einen NMOS-Transistor (T11 bzw. T22) und einen PMOS-Transistor (T12 bzw. T21) aufweist, die immer gleichzeitig leitend oder nichtleitend schaltbar sind, wobei im Einschaltzustand deren parallel zueinander liegende Einschaltwiderstände (Ron) den je zugehörigen Widerstand des Dämpfungsgliedes (SO bis Sn) bilden.

8. Stummsteuerschaltung nach Anspruch 6 oder 7, bei welcher die Zähler (11) und Dämpfungsschaltung (13) verbindende Datenleitung (15) als parallele Datenleitung mit n Bit-Leitungen ausgebildet ist und der Steuersignaleingang der Dämpfungsschaltung (13) dementsprechend n Steuersignalanschlüsse (E0 bis En) aufweist
und bei welcher bei jedem Dämpfungsglied (SO bis Sn) der zum ersten Widerstand gehörende NMOS-Transistor (T11) und der zum zweiten Widerstand gehörende PMOS-Transistor (T21) direkt und der zum ersten Widerstand gehörende PMOS-Transistor (T12) und der zum zweiten Widerstand gehörende NMOS-Transistor (T21) über einen Inverter (INV) mit dem zugehörigen Steuersignalanschluß (E0 bis En) verbunden sind, oder umgekehrt.

**Claims**

1. An electric muting circuit for soft muting of an audio signal (AS),
comprising a digitally controllable attenuation circuit (13) having an audio signal input (25), an audio signal output (27) and a control signal input (E0 to En), and comprising an up/down counter (11) having a count signal output (DO to Dn) from which a digital count signal is available and which is connected to the control signal input (E0 to En) of the attenuation circuit (13),
**characterized in**
**that** the up/down counter (11) comprises a clock pulse input (17) for being fed with clock pulses (CLK) to be counted and a counting control input (21) for being fed with a counting control signal (MUTE ON/MUTE OFF) controlling counting start and counting stop,
**that** a digital count signal in the form of an n-position data word can be delivered from the count signal output (DO to Dn) of counter (11) to the control signal input (E0 to En) of attenuation circuit (13), with n being a predetermined integer,
and **that** the attenuation circuit (13) contains a parallel connection connected between audio signal input (25) and a signal ground terminal (SGND) and including n attenuation members (S0 to Sn) each comprising:

a partial voltage tap (TA) connected to the audio signal output (27),
a first series connection connected between audio signal input (25) and partial voltage tap (TA) and including a first resistor (Ron) and a first controllable switch (T1),
a second series connection connected between partial voltage tap (TA) and signal ground terminal (SGND) and including a second resistor (Ron) and a second controlled switch (T2),
and a switch control means through which the two switches of each attenuation member are controllable in opposite manner such that in each particular case one of the two switches (T1, T2) is rendered conducting and the respective other switch (T2, T1) is rendered non-conducting,
with the switch control means of the attenuation members (S0 to Sn) being each adapted to be fed with a different one of the n positions of the data word as switching control signal,

and with the resistances of the resistors (Ron) of the individual attenuation members (S0 to Sn) being different, depending on the significance of the positions of the data word associated with the individual attenuation members (S0 to Sn).

2. The muting circuit of claim 1,
in which the clock pulse input (17) of counter (11) is adapted to be fed with a clock pulse signal (CLK) having a clock frequency that is variable in predeterminable manner.

3. The muting circuit of claim 2,
in which the clock signal input (17) of counter (11) is connected to a clock pulse source of variable pulse frequency.

4. The muting circuit of claim 2,
in which the clock pulse input (17) of counter (11) is adapted to be connected to one of several clock pulse sources (F1 to Fm) of different clock frequency in selectable manner via a selection means (19).

5. The muting circuit of any one of claims 3 to 4,
in which the variable clock pulse frequency or the selection means (19), respectively, is controllable in accordance with at least one selection program, under the control of which the clock pulse input (17) of counter (11) can be fed with a clock signal (CLK) having a clock frequency changing in predetermined manner.

6. The muting circuit of any one of claims 1 to 5,
in which each switch is composed with a MOS switch, the ON-resistor (Ron) of which constitutes the respectively associated resistor of the attenuation member (S0 to Sn).

7. The muting circuit of claim 6,
in which each MOS switch is composed with a parallel connection having an NMOS transistor (T11 and T22, respectively) and a PMOS transistor (T12 and T21, respectively) which can be rendered conducting or non-conducting always at the same time, wherein, in the ON-state, the ON-resistors (Ron) thereof arranged parallel to each other constitute the respectively associated resistor of the attenuation member (S0 to Sn).

8. The muting circuit of claim 6 or 7,
in which the data line (15) connecting counter (11) and attenuation circuit (13) is composed as a parallel data line with n bit lines and the control signal input of attenuation circuit (13) has in corresponding manner n control signal terminals (E0 to En), and in which, for each attenuation member (S0 to Sn), the NMOS transistor (T11) belonging to the first resistor and the PMOS transistor (T21) belonging to the second resistor are connected directly to the associated control signal terminal (E0 to En), and the PMOS transistor (T12) belonging to the first resistor and the NMOS transistor (T21) belonging to the second resistor are connected to the associated control signal terminal (E0 to En) via an inverter (INV), or vice versa.

## Revendications

1. Circuit de silencieux électrique pour la commutation douce à l'état silencieux d'un signal audio (AS), comprenant

   un circuit d'affaiblissement (13) à commande numérique qui présente une entrée de signal audio (25), une sortie de signal audio (27) et une entrée de signal de commande (E0 à En), et

   un compteur/décompteur (11) présentant une sortie de signal d'état de comptage (D0 à Dn), au niveau de laquelle on peut prélever un signal numérique d'état de comptage et qui est connectée à l'entrée de signal de commande (E0 à En) du circuit d'affaiblissement (13),

   **caractérisé en ce que**

   le compteur/décompteur (11) comporte une entrée d'impulsions d'horloge (17), destinée à recevoir des impulsions d'horloge (CLK) à compter, et une entrée de commande de comptage (21) destinée à recevoir un signal de commande de comptage (MUTE MARCHE/MUTE ARRET) commandant un départ de comptage et un arrêt de comptage,

   **en ce que** la sortie de signal d'état de comptage (D0 à Dn) du compteur (11) peut délivrer à l'entrée de signal de commande (E0 à En) du circuit d'affaiblissement (13) un signal numérique d'état de comptage sous la forme d'un mot de données à n positions, n étant un nombre entier prédéterminé,

   et **en ce que** le circuit d'affaiblissement (13) comprend un montage en parallèle qui est connecté entre l'entrée de signal audio (25) et une borne de mise à la masse de signal (SGND) et comporte n éléments affaiblisseurs (S0 à Sn) qui présentent chacun: une prise de tension partielle (TA) connectée à la sortie de signal audio (27); un premier circuit série qui est connecté entre l'entrée de signal audio (25) et la prise de tension partielle (TA) et comporte une première résistance (Ron) et un premier interrupteur (T1) commandé; un second circuit série qui est connecté entre la prise de tension partielle (TA) et la borne de mise à la masse de signal (SGND) et comporte une seconde résistance (Ron) et un second interrupteur (T2) commandé; et un dispositif de commande d'interrupteur, par lequel les deux interrupteurs de chaque élément affaiblisseur peuvent être commandés de manière telle que chaque fois l'un des deux interrupteurs (T1, T2) soit commuté à l'état passant et l'autre interrupteur (T2, T1) soit commuté à l'état non passant,

   chaque fois une autre position des n positions du mot de données pouvant être transmise en tant que signal de commande de commutation aux dispositifs de commande d'interrupteur des éléments affaiblisseurs (S0 à Sn), et les valeurs ohmiques des résistances (Ron) des différents éléments affaiblisseurs (S0 à Sn) étant différentes, en fonction des valences des positions du mot de données associées aux différents éléments affaiblisseurs (S0 à Sn).

2. Circuit de silencieux selon la revendication 1, dans lequel un signal d'impulsion d'horloge (CLK) peut être envoyé à l'entrée d'impulsions d'horloge (17) du compteur (11) avec une fréquence de cycle pouvant être modifiée de manière prédéterminée.

3. Circuit de silencieux selon la revendication 2, dans lequel l'entrée d'impulsions d'horloge (17) du compteur (11) est connectée à une source d'impulsions d'horloge à fréquence de cycle variable.

4. Circuit de silencieux selon la revendication 2, dans lequel l'entrée d'impulsions d'horloge (17) du compteur (11) peut être connectée à l'une parmi plusieurs sources d'impulsions d'horloge (F1 à Fm) à fréquences de cycle différentes, avec possibilité de sélection par un dispositif de sélection (19).

5. Circuit de silencieux selon une des revendications 3 et 4, dans lequel la source d'impulsions d'horloge variable et/ou le dispositif de sélection (19) peut être commandé(e) suivant au moins un programme de sélection, sous la commande duquel un signal d'horloge (CLK) à fréquence de cycle variant de manière prédéterminée peut être envoyé à l'entrée d'impulsions d'horloge (17) du compteur (11).

6. Circuit de silencieux selon une des revendications 1 à 5, dans lequel chaque interrupteur est construit avec un interrupteur MOS dont la résistance de commutation à l'état passant (Ron) constitue la résistance associée de l'élément affaiblisseur (S0 à Sn).

7. Circuit de silencieux selon la revendication 6, dans lequel chaque interrupteur MOS est construit avec un montage en parallèle présentant un transistor NMOS (T11 et T22) et un transistor PMOS (T12 et T21) qui peuvent être commutés de manière à être toujours simultanément à l'état passant ou à l'état non passant, les résistances de commutation à l'état passant (Ron) mutuellement parallèles de ces transistors constituant la résistance respective associée de l'élément affaiblisseur (S0 à Sn), à l'état passant.

8. Circuit de silencieux selon la revendication 6 ou 7, dans lequel la ligne de données (15) reliant le compteur (11) au circuit d'affaiblissement (13) est réalisée sous forme de ligne de données parallèle à n lignes de bits, et l'entrée de signal de commande du circuit d'affaiblissement (13) présente de manière correspondante n bornes de signal de commande (E0 à En), et dans lequel, au niveau de chaque élément affaiblisseur (S0 à Sn), le transistor NMOS (T11) appartenant à la première résistance et le transistor PMOS (T21) appartenant à la seconde résistance sont connectés directement à la borne de signal de commande (E0 à En) associée et le transistor PMOS (T12) appartenant à la première résistance et le transistor NMOS (T21) appartenant à la seconde résistance étant connectés via un inverseur (INV), ou vice versa.

F1

F2

F3

Fm

Mute ein / Mute aus

CLK

Aufwärts / Abwärts-Zähler

$D_0$  $D_1$  $D_2$  $D_3$  $D_4$  $D_n$

$E_0$  $E_1$  $E_2$  $E_3$  $E_4$  $E_n$

Digital gesteuerte
Dämpfungsschaltung

Audio Ein

Audio Aus

SGND

Fig. 1

EP 0 821 478 B1

Fig. 2

Mit fester Taktfrequenz

A1

AS

t0    t1         t2         t3         t4

Mute Ein      Mute Fertig      Mute Aus      Mute Fertig

A1

AS

Mit mehreren Taktfrequenzen bzw. variabler Taktfrequenz

A1

AS

Fig. 3

Mute Ein      Mute Fertig      Mute Aus      Mute Fertig

A1

AS

Fig. 4

Digitale Ansteuerung
Aufwärts / Abwärts - Zähler

$D_0$ (LSB) $D_1$  $D_2$  $D_3$  $D_4$ $D_n$ (MSB)

CLK

$E_0$  $E_1$  $E_2$  $E_3$  $E_4$  $E_n$

Audio Ein

$R_{ON}$

T1

TA

INV

$R_{ON}$

T2

Audio Aus

$R_{on} \times 2^n$  $R_{on} \times 1$

$G_0$  $G_1$  $G_2$  $G_3$  $G_4$  $G_n$

Digital gesteuerte Dämpfungsschaltung

SGND

EP 0 821 478 B1

Fig. 5

$E_n$

$G_n$

INV

Audio Ein

Ron
N
T11

Ron
P
T12

TA

Audio Aus

Ron
P
T21

Ron
N
T22